# EUROPEAN PATENT SPECIFICATION

(11) **EP 1 387 605 B1**
(45) Date of publication and mention of the grant of the patent: **18.03.2009**
(21) Application number: 02258870.1
(22) Date of filing: 23.12.2002
(51) Int. Cl.: H05K 3/46, H05K 1/03, H05K 3/28

(54) **Multilayered printed wiring board**
Mehrschichtige gedruckte Leiterplatte
Panneau à circuit imprimé multicouche

(30) Priority: 29.07.2002 JP 2002219217
(43) Date of publication of application: 04.02.2004
(73) Proprietor: FUJI ELECTRIC CO., LTD., Kawasaki-shi, Kanagawa 210-0856 (JP)
(72) Inventor: Saito, Shigemasa, Kawasaki 210-0856 (JP)
(74) Representative: Haley, Stephen

(56) References cited:
- WO-A-01/70844
- US-A- 4 948 700
- US-A- 5 955 184
- US-A1- 2001 049 009
- US-B1- 6 403 221
- PATENT ABSTRACTS OF JAPAN vol. 2000, no. 13, 5 February 2001 (2001-02-05) & JP 2000 290474 A (ASAHI CHEM IND CO LTD), 17 October 2000 (2000-10-17)
- PATENT ABSTRACTS OF JAPAN vol. 2000, no. 19, 5 June 2001 (2001-06-05) & JP 2001 049085 A (TOSHIBA CHEM CORP), 20 February 2001 (2001-02-20)
- PATENT ABSTRACTS OF JAPAN vol. 1995, no. 01, 28 February 1995 (1995-02-28) & JP 06 302926 A (SUMITOMO BAKELITE CO LTD), 28 October 1994 (1994-10-28)
- PATENT ABSTRACTS OF JAPAN vol. 018, no. 133 (M-1571), 4 March 1994 (1994-03-04) & JP 05 318650 A (TOSHIBA CHEM CORP), 3 December 1993 (1993-12-03)

## Description

The present invention relates to a printed wiring board for surface mounting electronic parts, and more particularly to a multilayered printed wiring board each of whose insulators layer is made up of a glass cloth and epoxy resin.

For a printed wiring board for surface mounting electronic parts, there is a copper-clad paper phenol laminate referred to as FR-1, a copper-clad composite laminate referred to as CEM-3, a resin sheet with a copper foil referred to as RSC for a build-up, a multilayered copper-clad glass epoxy laminate referred to as FR-4 under NEMA (National Electrical Manufacturers Association, U.S.) Standard, or the like, which is used to required performance of an apparatus being used. Of the above, the multilayered copper-clad glass epoxy laminate referred to as FR-4 is a multilayered printed wiring board each of whose insulator layers is made up of glass cloth and epoxy resin. A large amount of the wiring boards is used to recently become a main components mounted in such an apparatus as a personal computer, a cellular phone, and the like.

A temperature of such a printed wiring board becomes high in some electric circuit. Thus, fire retardancy is required for the board from the view point of safety for the purpose of fire prevention, for which there is established a standard of fire retardancy grade such as UL94-V0

In general, for making such a board material fire retardant, it is known that halogen material is effectively added. Such a fire retardant component is generally used while being added to or made reacted with resin. Such fire retardant additive makes high fire retardancy exhibited with a mechanism in which generation of halogenated radicals mainly due to pyrolysis captures inorganic radicals as combustion sources to stop chain reactions for combustion.

Here, in the copper-clad glass epoxy laminate like the above-described FR-4, an insulator layer is made up of glass cloth and epoxy resin. Therefore, fire retardancy has been previously imparted to the epoxy resin by using chlorinated epoxy resin or brominated epoxy resin as the epoxy resin.

However, the fire retardant additive including a large amount of halogen compound such as brominated epoxy resin has a possibility of generating dioxin under some combustion condition. Therefore, from the viewpoint of reducing load to environment becoming topical recently, requirement is increasing for reducing the amount of halogen. In addition, there is also a problem in which liberated halogen ions migrate into the copper foil layer to cause a phenomenon referred to as migration that induces corrosion of the copper foil layer provided as a circuit.

As a board material that reduces an amount of halogen being used while thus maintaining fire retardancy, there is disclosed in, for example, JP-A-2001-164094 a fire retardant insulating epoxy composition as an insulator film used for a build up being provided with fire retardancy and insulation characteristics required for a circuit board. The composition includes epoxy resin, a curing agent for the epoxy resin, resorcinol phosphate ester, aluminum hydroxide, and an epoxy curing agent.

Moreover, in JP-A-2000-290474, as a hardening resin composition to which sufficient fire retardancy is imparted, there is disclosed a hardening resin composition containing polyphenylene ether resin, bisphenol A epoxy resin, novolak phenolic resin, melamine or guanamine, phosphorus compound, and inorganic filler.

Document EP-A-1273608 describes a resin composition suitable for printed circuits containing a wide variety of components.

In the compositions disclosed in the above-described JP-A-2001-164094 and JP-A-2000-290474, fire retardancy is imparted by inorganic components such as phosphorus compound, aluminum hydroxide, and the like, by which it is made possible to reduce halogen.

However, in the fire retardant insulating epoxy composition disclosed in J P-A-2001-164094, an application object thereof is a printed wiring board made by a build up method using no glass cloth. Thus, the composition can not be directly applied to the multilayered copper-clad glass epoxy laminate. Moreover, phosphorus ester and aluminum hydroxide used only in combination as fire retardant components make it difficult to obtain the fire retardancy equivalent to that in UL-VO to present a problem of providing insufficient fire retardancy.

In addition, also in the resin composition disclosed in JP-A-2000-290474, composition and mixing amounts of inorganic fillers are not restrictive to present a problem of providing insufficient fire retardancy.

Furthermore, in each of the compositions disclosed in the above-described JP-A-2001-164094 and JP-A-2000-290474, there is also a problem of providing low thermal conductivity of the insulator layer. In general, inorganic fillers such as aluminum hydroxide are liable to cause secondary flocculation of the order of 10 to 20µm. The flocculation is also caused when inorganic fillers are distributed in the resin. Thus, it is difficult to uniformly distribute inorganic fillers in the insulator layer. Consequently, in the above-described conventional compositions, some portions of the insulator layer have been formed as those being resin rich. This reduces thermal conductivity of the insulator layer to cause insufficient dissipation of heat when electronic parts are soldered by a reflow furnace or like that, which has presented a problem of being liable to damage the electronic parts.

Further, in the multilayered printed wiring board, recent downsizing and performance improvement thereof cause the operating condition thereof to become severe, which requires rapid improvement in reliability in machinability of the board and the like in addition to improvement in the above-described thermal property. For example, in the multilayered printed wiring board, through-holes are provided for providing continuity between metal foil layers laminated with an insulator layer put between. Drilling machinability of the insulator layer in providing the through-holes is liable to be reduced when an amount of added inorganic fillers is increased for ensuring fire retardancy. Therefore, reduction in drilling machinability must be prevented when adding such inorganic fillers as above.

The present invention was made in view of the above problems with an object of providing a multilayered printed wiring board to which fire retardancy is imparted while reducing amounts of halogen compounds being used, yet which is made to have enhanced thermal conductivity of an insulator layer to prevent electronic parts from being damaged at soldering and is excellent in drilling machinability in forming through-holes.

For achieving the above-described object, a multilayered printed wiring board according to the invention is characterized in that, in a multilayered printed wiring board wherein insulator layers each being formed with a glass cloth impregnated with epoxy resin composition and metal foil layers in each of which a circuit is formed are laminated alternately so that each of the above-described metal layers are disposed on each of a top and a bottom sides of the above-described insulator layer, and through-holes are further provided each for providing continuity between the metal foil layers laminated with the above-described insulator layer put between,
the above-described epoxy resin composition includes at least phosphate ester, aluminum hydroxide, silica, calcium oxide, strontium titanate, and iron oxide, and
contents of inorganic components in the above-described insulator layer are provided so as to be 8 to 18% by mass of phosphorus pentoxide (P₂O₅), 20 to 28% by mass of aluminum oxide (Al₂O₃), 0.1 to 0.6% by mass of silica (SiO₂), 0.1 to 1.0% by mass of chlorine (Cl), 15 to 20% by mass of calcium oxide (CaO), 0.3 to 0.5% by mass of titanium oxide (TiO₂), 0.2 to 0.4 of iron oxide (Fe₂O₃), and 0.1 to 0.3% by mass of strontium oxide (SrO) in converted values measured by an X-ray fluorescence analysis.

According to the invention, phosphate ester and aluminum hydroxide, being used so as to be contained with such amounts as described above, can impart fire retardancy while reducing amounts of halogen compounds being used.

Moreover, silica, calcium oxide, strontium titanate, and iron oxide are further contained in the above-described proportions. This can prevent secondary flocculation of aluminum hydroxide in the insulator layer to enhance thermal conductivity of the insulator layer, which can prevent electronic parts from being damaged at soldering.

Furthermore, relatively low contents of inorganic components causes no reduction in drilling machinability in forming through-holes.

In the invention, it is preferable that the above-described aluminum hydroxide is made up of particles with irregular shapes having average particle diameter of 0.5 to 1.0µm almost uniformly distributed in the above-described insulator layer. This can effectively prevent the aluminum hydroxide particles from secondary flocculation to further enhance thermal conductivity of the insulator layer.

Moreover, in the invention, it is preferable that, at specified sections in the above-described metal foil layers and through-holes, there are formed solder layers which contain no lead. This can further provide a multilayered printed wiring board as being lead-free in addition to being halogen-reduced, which can reduce load to environment as the whole wiring board.

Furthermore, in the invention, it is preferable that a surface of the multilayered printed wiring board except for sections to be soldered is coated with an insulation material containing phthalocyanine blue. This can remove halogen also from resist coat material on a surface of the wiring board, which can reduce amount of halogen as the whole multilayered printed wiring board to reduce load to environment.

In addition, in the invention, it is preferable that amounts of gases evolved by a burning test at 600°C specified under JIS-K7217 are 150µg/g or less of chlorine, 30mg/g or less of bromine, 5mg/g or less of hydrogen cyanide, and 5pg/g or less of polychlorinated dibenzo-p-dioxin and polychlorinated dibenzo furan in mass ratio to the above-described multilayered printed wiring board. This can suppress halogen and dioxin as injurious materials from being produced, by which a multilayered printed wiring board can be provided as being safety even when being burnt.

Further, in the invention, it is preferable that thermal conductivity of the above-described insulator layer is 0.4 to 0.5W/m/K. This, because of the high thermal conductivity of the insulator layer, can prevent electronic parts from being damaged at soldering.

In the following, the multilayered printed wiring board according to the invention will be explained in detail by using drawings, in which:-
Fig. 1 is a schematic view showing a laminated structure of a multilayered printed wiring board according to the invention.
Fig. 2 is a schematic process diagram showing a method of manufacturing the multilayered printed wiring board according to the invention.
Fig. 3 is a SEM image of a cross section of an insulator layer section in the multilayered printed wiring board in an Example 1.
Fig. 4 is a SEM image of a cross section of an insulator layer section in a multilayered printed wiring board in a Comparison Example 1.
Fig. 5 is a SEM image of a cross section of an insulator layer section in a multilayered printed wiring board in a Comparison Example 2.

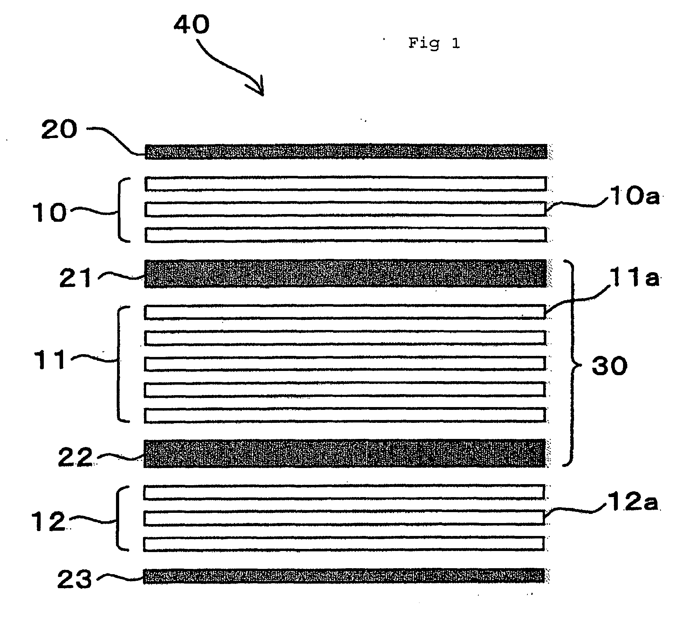

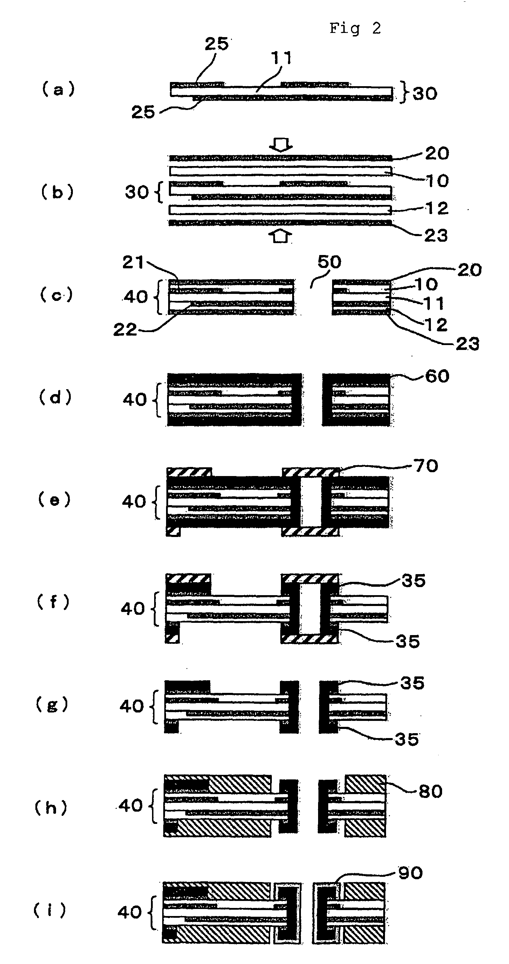

In Fig. 1 and Fig. 2, there is shown an example of a method of manufacturing the multilayered printed wiring board according to the invention. Figure 1 is a schematic view showing a structure of a laminated state of the multilayered printed wiring board according to the invention, and Figure 2 is a schematic process diagram of the method of manufacturing the multilayered printed wiring board according to the invention.

As shown in Fig. 1, the multilayered printed wiring board is integrated with insulator layers 10, 11, 12 and metal foil layers 20, 21, 22, 23 being alternately laminated so that the above-described metal foil layers are disposed on both sides of the insulator layer 10,11,12 to be in a four-layer plate structure with four layers of the metal foil layers. In the invention, the number of lamination of the multilayered printed wiring board is not particularly limited. Thus, six-layer structure may be possible in which an insulator layer and a metal foil layer are further provided on each of the top and bottom faces.

Moreover, each insulator layer includes a plurality of prepregs each made up of a glass cloth impregnated with epoxy resin composition. In Fig. 1, the central insulator layer 11 is laminated with five prepregs 11a, and the insulator layers 10 and 12 are laminated with three prepregs 10a and 12a, respectively.

First, an explanation will be made about prepreg 10a, 11a, and 12a used in the invention each obtained by impregnating a glass cloth with epoxy composition.

For the glass cloth, a previously known glass fibers fabric can be used without any particular limitation thereto. For example, there are preferably used a glass cloth with glass yarn of G75 1/0 specified under JIS-R3413 in a number of yarns per inch of 44 32/inch, a glass cloth with glass yarn of DE150 1/0 in a number of yarns per inch of 60 50/inch, a glass cloth with glass yarn of E225 1/0 in a number of yarns per inch of 60 58/inch, a glass cloth with glass yarn of D450 1/0 in a number of yarns per inch of 60 47/inch.

Next, an explanation will be made about the epoxy resin composition used in the invention. In the invention, it is taken as a first characteristic that the epoxy resin composition includes at least phosphate ester, aluminum hydroxide, silica, calcium oxide, strontium titanate, and iron oxide.

For the epoxy resin, there is no particular limitation, but bifunctional epoxy resin such as bisphenol A epoxy resin, bisphenol F epoxy resin, and the like, and multifunctional epoxy resin such as phenolic novolak epoxy resin, cresol novolak epoxy resin, bisphenol A novolak epoxy resin, bisphenol F novolak epoxy resin, naphthalene epoxy resin, biphenyl epoxy resin, dicyclopentadiene epoxy resin, and the like can be used independently or in combination of a plurality thereof. Aromatic epoxy resin is preferable and bisphenol A epoxy resin is preferably used in particular.

Moreover, it is in particular preferable for epoxy resin that the epoxy resin is chlorinated with chlorine content within a range of not exceeding the later explained amount because such content enhances fire retardancy. As such epoxy resin, there is named, for example, low chlorinated bisphenol A. Further, for hardener, there is also no limitation, but there are named phenolic resin and phenolic novolak resin, for example, of which phenolic novolak resin is preferably used. This is because the resin has toughness with low brittleness, allows peel strength off the metal foil layer to be established high, and is further capable of inhibiting evolution of NOx.

The phosphate ester is made included for imparting fire retardancy in the invention. The phosphate ester is pyrolytically decomposed to produce phosphoric acid, polyphosphoric acid, and polymetaphosphoric acid, by whose dehydration-carbonization-catalytic actions, an oxide layer is formed on the surface of the resin to enable to enhance fire retardancy. For phosphate ester, there is no limitation, but there are named bisphenol phosphate ester, resorcinol phosphate ester, for example, of which resorcinol phosphate ester is preferably used in respect to ensured fire retardancy.

The aluminum hydroxide is made included for imparting fire retardancy in the invention. The aluminum hydroxide is considered to be pyrolytically decomposed to release water of crystallization, which suppresses oxidation reaction by a cooling effect of the water. It is preferable that the aluminum hydroxide is made up of particles with irregular shapes having average particle diameter of 0.5 to 1.0µm which are almost uniformly distributed in the above-described insulator layer. This can effectively prevent the aluminum hydroxide particles from secondary flocculation to further enhance thermal conductivity of the insulator layer.

In the invention, the irregular shapes mean that the shapes of the particles are those including not only spherical one but also needle-like and flat plate-like ones. Such aluminum hydroxide can be obtained by making aluminum hydroxide dispersed by a zirconia coated bead mill, for example.

Aluminum hydroxide with an averaged particle diameter less than 0.5µm is liable to cause secondary flocculation, which results in nonuniform dispersion in the insulator layer to unpreferably reduce thermal conductivity of the insulator layer. The averaged particle diameter exceeding 1.0µm causes a resin rich layer with low heat-resistance due to epoxy resin to be formed between aluminum hydroxide particles to thereby unpreferably reduce heat-resistance to soldering and fire resistance characteristics.

In the invention, at least silica, calcium oxide, strontium titanate, and iron oxide are further included in the epoxy resin composition as inorganic components.

By combining a plurality of the above-described inorganic components, in the process steps of melting, flowing, and solidifying the resin in laminating process of the insulator layer, there can be inhibited uneven distribution of aluminum hydroxide and epoxy resin due to difference in physical properties of materials, for example, formation of large resin rich layers. Moreover, for securing fire resistance, adhesion, strength, electrical characteristics, and the like, the particle diameters of the above-described inorganic components are preferably 1mm or less in averaged particle diameter.

Furthermore, in the invention, it is taken as a second characteristic that contents of inorganic components in the above-described insulator layer are provided so as to be 8 to 18% by mass of phosphorus pentoxide (P₂O₅), 20 to 28% by mass of aluminum oxide (Al₂O₃), 0.1 to 0.6% by mass of silica (SiO₂), 0.1 to 1.0% by mass of chlorine (Cl), 15 to 20% by mass of calcium oxide (CaO), 0.3 to 0.5% by mass of titanium oxide (TiO₂), 0.2 to 0.4 of iron oxide (Fe₂O₃), and 0.1 to 0.3% by mass of strontium oxide (SrO) in converted values measured by an X-ray fluorescence analysis.

By making the inorganic components contained with the above-described contents, fire retardancy can be imparted while reducing amounts of halogen compounds being used, yet thermal conductivity of the insulator layer can be enhanced to prevent electronic parts from being damaged at soldering.

Here, the above-described contents are of inorganic components in the insulator layer of the multilayered printed wiring board after being manufactured and are presented in converted values measured by the X-ray fluorescence analysis. By using values thus measured by the X-ray fluorescence analysis, kinds and contents of the inorganic components can be accurately determined with the multilayered printed wiring board being in a state after manufactue.

Moreover, the values measured by the X-ray fluorescence analysis are of contents of the inorganic elements in the direction of depth exsisted down to on the order of several tens µm from the measured surface. Therefore, the compositions around the surface of the insulator layer directly related to the fire retardancy of the insulator layer are to be presented by the above-described contents.

Specific measurements are carried out by qualitative analyses of the inorganic elements by the X-ray fluorescence analysis and quantitative analyses by relative intensity method to X-rays of a reference material. In this case, the quantitative analysis can be carried out by preparing a calibration curve about every element or by using a so-called FP method in which a content of an element is determined by comparing a fluorescent X-rays intensity obtained from theory with a measured intensity.

In the X-ray fluorescence analysis, only amounts of inorganic elements in the measuring range are directly determined. Therefore, of the contents of the inorganic components, a value about phosphate ester is a converted value to that of phosphorus pentoxide (P₂O₅).

Of the contents of the inorganic components, a value about aluminum hydroxide is a converted value to that of aluminum oxide (Al₂O₃) that means a value including aluminum oxide included in the glass cloth components.

An amount of the above-described aluminum hydroxide can be calculated out by subtracting from the total weight of the insulator layer an amount of sum of a weight of a glass cloth base with the same size, amounts of inorganic materials obtained by ignition loss measurement, and an amount of phosphorus pentoxide measured by the X-ray fluorescence analysis.

The weight of the glass cloth base can be obtained by immersing aluminum hydroxide adhered and adsorbed to the glass cloth in perchloric acid solution and carrying out ultrasonic cleaning thereof to remove the aluminum hydroxide. The details of the method of determining an amount of the above-described aluminum hydroxide is described in JP-A-2002-6823 applied for by the same applicant.

Of the contents of the inorganic components, values about silica (SiO₂) and calcium oxide (CaO) also mean values including silica and calcium oxide included in the glass cloth components. Therefore, for example, the content of calcium oxide (CaO) becomes 14.7 to 19.5% by mass in the glass cloth, and 0.3 to 0.5% by mass in the epoxy resin, which means that the sum of the two is to become 15 to 20% by mass.

For the epoxy resin composition according to the invention, various kinds of additives can be used in addition to the above-described ones. For such additives, there can be named a silane coupling agent, an anti-oxidizing agent, a cure accelerating agent, various kinds of modifiers, and the like.

As a manufacturing method of the above-described epoxy resin composition, a raw material epoxy resin to be a base resin is dispersed by a bead mill with the above-described aluminum hydroxide, silica, calcium oxide, strontium titanate, and iron oxide added thereto before being solved in such a solvent as the above-described phosphate ester, polypropylene glycol monomethyl ether (PGM) or methyl ethyl ketone (MEK) for being made reacted, by which the composition can be obtained.

At this time, as the amounts of mixing the above-described components, the components are preferably mixed so that contents thereof become 160 to 180 parts by mass of epoxy resin, 17.1 to 38.4 parts by mass of phosphate ester, 44.9 to 62.8 parts by mass of aluminum hydroxide, 0.15 to 0.9 parts by mass of silica, 0.3 to 0.5 parts by mass of calcium oxide, 0.29 to 0.59 parts by mass of iron oxide, and 0.53 to 1.17 parts by mass of strontium titanate. Here, mass of the epoxy resin is a sum of those of the base resin and the curing agent. With this, contents of inorganic components in the insulator layer can be obtained which are measured by the above-described X-ray fluorescence analysis.

The epoxy resin composition can be impregnated into the glass cloth by using a previously known impregnating apparatus for providing a prepreg. To the drying condition and the like thereof, a conventional condition can be applied, so that no particular restriction is imposed. Moreover, it is preferable that the amount of impregnation is 48 to 52% by mass to the whole prepreg after being impregnated. Amount of impregnation of 48% by mass or less is unpreferably liable to develop a gap at an interface with the metal foil layer. Amount of impregnation exceeding 52% by mass unpreferably causes much squeeze-out of resin to result in nonuniform thickness.

In the next, an explanation will be made about a manufacturing method of a multilayered printed wiring board according to the invention using the above-explained prepregs.

First, as shown in Fig. 1, several of the above-described prepregs 11a are laminated (five in Fig. 1) with further lamination of metal foil films 21 and 22 on both sides, respectively. Thereafter, the lamination is integrated by heating and pressing to be formed into an inner layer board 30. This hardens a plurality of the prepregs 11a to form the insulator layer 11. For the metal foil layers 21 and 22, there is no particular limitation, but copper foils of 18 to 70µm are preferably used.

Next to this, as shown in Fig. 2(a), the metal foil layers 21 and 22 are subjected to etching to be formed into inner layer circuits 25 on both faces of the inner layer board 30, respectively. For an etching method, a method of using a conventionally known photosensitive resist material and the like is applicable, but there is no particular limitation thereto.

Subsequent to this, as shown in Fig. 1 and Fig. 2(b), on both faces of the inner layer board 30, there are laminated a plurality of the prepregs 10a and 12a (three for each in Fig. 1), both sides of which there are further laminated the metal foil layers 20 and 23, respectively. The lamination is thereafter integrated by heating and pressing to be formed into a board 40. This hardens a plurality of the prepregs 10a and 12a to formed the insulator layers 10 and 12, respectively.

Moreover, as shown in Figs. 2(c) and 2(d), for providing continuity for the metal foil layers 20, 21, 22, and 23 laminated with each of the insulator layers 10,11, and 12 put between the metal foils, a through hole 50 is provided by drilling or the like (Fig. 2(c)). Furthermore, for providing continuity for the through hole 50, the whole board is plated, by which plated layers 60 are provided (Fig. 2(d)). For the plated layers 60, conventionally known copper plating or the like is employed. For inhibiting oxidation of a copper surface due to heating at soldering to thereby ensure wetting, two or more of the plated layers can be provided. For example, a Au flashing can be given on a Ni plating.

By the through hole 50, continuity is provided among circuits of all of the metal foil layers. Moreover, the through hole 50 is also served as a hole for inserting and soldering a lead of an electronic part. At this time, in the multilayered printed wiring board according to the invention, contents of inorganic components being within the above-described range causes no deterioration in drilling machinability.

Further, as shown in Figs. 2(e) to 2(g), each of the metal foil layers 20 and 23 on each surface is masked with a dry film 70 (Fig. 2(e)). Thereafter, the plated layers 60 and the metal foil layers 21 and 22 are etched to be formed into outer layer circuits 35 on both of the faces of the board 40 (Fig. 2(f)). After this, the dry films 70 are removed (Fig. 2 (g)).

Furthermore, for preventing solder from spreading out of sections to be soldered, portions other than the sections to be soldered are coated with solder resists 80 (Fig. 2(h)). Here, the sections to be soldered are referred to as sections of the outer layer circuits 35 to which sections lead terminals of electronic parts are directly soldered in addition to the through hole 50 as shown in Fig. 2 to which an electronic part is soldered.

Here, in the invention, the solder resists 80 preferably contain phthalocyanine blue. This can remove halogen also from the solder resist on the surface of the wiring board, which can reduce load to environment as the whole multilayered printed wiring board.

Finally, on the sections to be soldered, that is, on the plated layers 60 exposed to the surface, solder coating 90 is provided for enhancing adhesion to solder (Fig. 2(i)).

Here, in the invention, the solder coating 90 is preferably a solder layer that contains no lead. This can further provide a lead-free multilayered printed wiring board, which can reduce load to environment as the whole wiring board.

As such solder coating 90, there is named a Sn-Ag-Cu alloy, a Sn-Zn-Bi alloy, a Ni-Au alloy, or the like.

The multilayered printed wiring board according to the invention obtained by the above manufacturing method is imparted with fire retardancy while amounts of halogen compounds used being reduced, yet is made to have enhanced thermal conductivity of an insulator layer to prevent electronic parts from being damaged at soldering and is excellent in drilling machinability in forming through-holes.

Specifically, about generation of injurious gas from the multilayered printed wiring board according to the invention, it is preferable that amounts of gases evolved by the burning test at 600°C specified under JIS-K7217 are 150mg/g or less of chlorine, 30µg/g or less of bromine, 5mg/g or less of hydrogen cyanide, and 5µg/g or less of polychlorinated dibenzo-p-dioxin and polychlorinated dibenzo furan in mass ratio to the above-described multilayered printed wiring board.

Here, measuring methods for concentrations of chlorine and bromine are the measuring methods specified under JPCA-ES-01-1999 published by Japan Printed Circuit Association.

Moreover, measuring methods for concentrations of hydrogen cyanide (HCN), and PCDD and PCDF as chlorinated dioxin are values for which soot and gases, evolved when burning the multilayered printed wiring board under conditions of a burning temperature at 600°C, an oxygen concentration at 21%, and a flow rate of supplied gas at 1.5L/min, are caught by a quartz cylinder filter paper, diethylene glycol, and XAD-2 resin, and analyzed by a GC/MS.

Furthermore, it is preferable that thermal conductivity of the insulator layer of the multilayered printed wiring board according to the invention is 0.4 to 0.5W/m/K. The measured value of the thermal conductivity is a value measured by a laser flash method at 25°C in vacuum environment.

According to this, because of the high thermal conductivity of the insulator layer, can prevent electronic parts from being damaged at soldering.

Namely, for a conventional multilayered printed wiring board with thermal conductivity of the insulator thereof being low, temperature setting at soldering is made as being rather high for the purpose of increasing productivity. Thus, the temperature setting at soldering is generally made higher by 40 to 50°C than the melting point of solder.

Such a high temperature setting as to considerably exceed a melting point enhances thermal stresses in electronic parts to give large damages to the electronic parts. Moreover, an elevated heating temperature prolongs a time to solidification of solder material to cause fillet peeling (lift-off) phenomenon and the like when lead-free solder with high melting point is used, which results in possible decrease in reliability at a connected portion.

In this respect, since the multilayered printed wiring board according to the invention has a high thermal conductivity, a heating temperature at soldering can be set low. This decreases thermal stress to make it possible to prevent damage to electronic parts. Moreover, solder is allowed to solidify in a short time to make the above-described peeling phenomenon hard to occur, which can increase reliability at a connected portion.

In the following, the invention will be explained in more detail by examples.

### Example 1

By the manufacturing process shown in Fig. 2, a multilayered printed wiring board with four-layer structure as shown Fig. 1 was manufactured.

### <Adjustment of the Epoxy Resin Composition>

For a base resin, low chlorinated bisphenol A epoxy resin (manufactured by Asahi Denka Kogyo K.K. under the trade name of KRM2414) of 60 parts by mass, high fire retardant polyfunctional cresol-novolak epoxy resin (manufactured by Asahi Denka Kogyo K.K. under the trade name of KRM2650) of 40 parts by mass, rubber modified epoxy resin (manufactured by Asahi Denka Kogyo K.K. under the trade name of KRM2423) of 10 parts by mass, fire retardant aluminum hydroxide with 30µm averaged particle diameter (manufactured by Nippon Light Metal Co., Ltd. under the trade name of B303) of 49.35 parts by mass, silica with 20µm averaged particle diameter (manufactured by Nippon Steel Chemical Co., Ltd. under the trade name of M-20) of 0.6 parts by mass, calcium oxide with 0.3µm averaged particle diameter (manufactured by Nippon Sekkai Kogyo-sho Co., Ltd. under the trade name of CALCIA) of 0.5 parts by mass, strontium titanate with 1.0µm averaged particle diameter (manufactured by Fuji Titanium Industry Co., Ltd. under the trade name of HPSF-2) of 0.9 parts by mass, and iron oxide with 400Å averaged particle diameter (manufactured by Sumitomo Cement Co., Ltd. under the trade name of FERRITE) of 0.44 parts by mass were dispersed by a bead mill.

Thereafter, resorcinol phosphate ester as being high sensitive phosphate ester (manufactured by Asahi Denka Kogyo K.K. under the trade name of FP-500) of 29.70 parts by mass, high strength phenol novolak resin (manufactured by Dainippon Ink and Chemicals Inc. under the trade name of EPICRON N-770) of 57.36 parts by mass, and curing catalyst (manufactured by Asahi Denka Kogyo K.K. under the trade name of EH-4339S) of 0.9 parts by mass are made solved in a solvent including propylene glycol monomethyl ether acetate (PGMAC) and methyl ethyl ketone (MEK), by which there was obtained the epoxy resin composition according to the invention.

### <Preparation of the Prepreg>

The above-described epoxy resin composition was made impregnated into glass cloth (manufactured by Asahi Shabel K.K. under the trade name of STYLE 1560) and made dried using a vertical drying oven, by which a prepreg with a thickness of 0.18mm was obtained.

### <Manufacturing of the Multilayered Printed Wiring Board>

According to the manufacturing process in Fig. 2, on each face of a laminated composition consisting of the above-described five prepregs, a copper foil with a thickness of 70mm was laminated. A vacuum hot-press of the prepregs was thereafter carried out at 170°C for 70 minutes to form an inner layer board 30. After this, the metal foil layers 21 and 22 were subjected to etching to be formed into inner layer circuits 25 on both surfaces of the inner layer board 30, respectively.

Furthermore, on both of front and back faces of the inner layer board 30, three of prepregs 10a and three of prepregs 12a were laminated to be the prepregs 10 and 12, respectively. On both sides of the lamination, each of the metal foil layers 20 and 23 were further laminated. Thereafter, a vacuum hot-press at 170°C for 70 minutes was carried out to form the board 40 of a four-layer structure with a thickness of 1.6mm.

After this, the through hole 50 was provided by carrying out drilling and the like before the whole board was copper plated to be provided as the plated layer 60 for continuity. Furthermore, the metal foil layers 20 and 23 on both sides were masked with the dry films before the plated layer 60 and the metal foil layers 21 and 22 were subjected to etching to be formed into outer layer circuits 25 on both faces of the board 40. Then, the dry films were removed.

Thereafter, portions other than the sections to be soldered were coated by a solder resist containing 0.4% of phthalocyanine blue (manufactured by Taiyo Ink Mfg. Co., Ltd. under the trade name of PSR-4000, BL01). Finally, on the sections to be soldered, that is, on the plated layers 60 exposed to the surface, solder coating was carried out with lead-free solder including Sn-3.2Ag-0.5Cu, by which the multilayered printed wiring board of the Example 1 was obtained.

### <Specification of inorganic components by fluorescent X-rays>

About the insulator layer sections of the above-described multilayered printed wiring board, measurement of inorganic components was carried out by fluorescent X-rays to obtain quantitative analysis values of phosphorus, aluminum, silicon, chlorine, calcium, titanium, iron, and strontium. Here, the measured values of the elements are converted values to phosphorus pentoxide (P₂O₅), aluminum oxide (Al₂O₃), silica (SiO₂), chlorine (Cl), calcium oxide (CaO), titanium oxide (TiO₂), iron oxide (Fe₂O₃), and strontium oxide (SrO), respectively. The unit thereof is percent by mass when the total amount of the epoxy compositions in the insulator layers is taken as 100%. Moreover, the values about the aluminum oxide are those after the above-described conversion. The results are summarized to be shown in Table 1.

**[Table 1]**

| | Al₂O₃ | SiO₂ | P₂O₅ | Cl | CaO | TiO₂ | Fe₂O₃ | SrO |
|---|---|---|---|---|---|---|---|---|
| Example 1 | 22 | 0.4 | 14 | 0.8 | 20 | 0.4 | 0.3 | 0.2 |
| Example 2 | 25 | 0.3 | 12 | 0.7 | 16 | 0.3 | 0.3 | 0.2 |
| Comparison Example 1 | 24 | 6 | 8 | 0.3 | 8 | 0.02 | 0.1 | 0.03 |
| Comparison Example 2 | 30 | 0.2 | 7 | 0.8 | 17 | 0.4 | 0.3 | 0.2 |

### Example 2

In the preparation of the epoxy resin composition in the Example 1, a multilayered printed wiring board in an Example 2 was obtained under the same conditions as those in the Example 1 except for addition of resorcinol phosphate ester of 25.6 parts by mass, aluminum hydroxide of 56.1 parts by mass, silica of 0.5 parts by mass, calcium oxide of 0.3 parts by mass, strontium titanate of 0.65 parts by mass, and iron oxide of 0.39 parts by mass as inorganic components.

### Comparison Example 1

In the preparation of the epoxy resin composition in the Example 1, a multilayered printed wiring board in a Comparison Example 1 was obtained under the same conditions as those in the Example 1 except for addition of resorcinol phosphate ester of 17.1 parts by mass, aluminum hydroxide of 53.9 parts by mass, silica of 90 parts by mass, calcium oxide of 0.2 parts by mass, strontium titanate of 0.007 parts by mass, and iron oxide of 0.44 parts by mass as inorganic components.

### Comparison Example 2

In the preparation of the epoxy resin composition in the Example 1, a multilayered printed wiring board in a Comparison Example 2 was obtained under the same conditions as those in the Example 1 except for addition of resorcinol phosphate ester of 14.9 parts by mass, aluminum hydroxide of 67.3 parts by mass, silica of 0.3 parts by mass, calcium oxide of 0.4 parts by mass, strontium titanate of 0.88 parts by mass, and iron oxide of 0.44 parts by mass as inorganic components.

### Examples of Tests

### <Fire Resistance Characteristics Test>

About the multilayered printed wiring boards in the Examples 1 and 2, and the Comparison Examples 1 and 2, burning characteristics tests specified under UL-94V0 were carried out. The results are summarized to be shown in Table 2.

### <Thermal Conductivity Test>

About the multilayered printed wiring boards in the Examples 1 and 2, and the Comparison Examples 1 and 2, thermal conductivity in each of the insulator sections were measured. The results are summarized to be shown in Table 2. The thermal conductivity was measured by a laser flash method at 25°C in vacuum environment using TC-7000 manufactured by Shinku Rika Co., Ltd. The results are summarized to be shown in Table 2.

### <Dispersed State of the Inorganic Fillers>

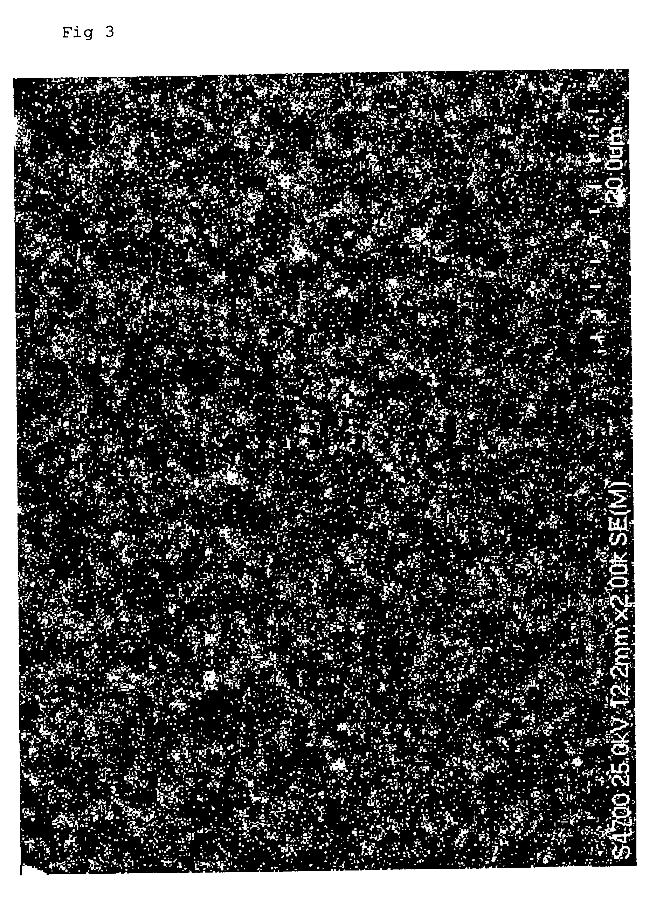

About the multilayered printed wiring boards in the Examples 1 and 2, and the Comparison Examples 1 and 2, cross sections of the insulator sections were observed under a scanning electron microscope (SEM) at X2000 for being evaluated about dispersed state of the inorganic fillers. The results are shown in Figs. 3 to 5.

**[Table 2]**

| | Fire Resistance Characteristics | Thermal Conductivity (w/m/k) |
|---|---|---|
| Example 1 | V0 | 0.45 |
| Example 2 | V0 | 0.44 |
| Comparison Example 1 | V0 | 0.28 |
| Comparison Example 2 | V1 | 0.47 |

From Table 2, in each of the Examples 1 and 2, since proportions of the inorganic components obtained by fluorescent X-rays were within the ranges according to the invention, fire retardancy was made to comply with V0. Yet, thermal conductivity was as high as 0.45W/m/K. This satisfied high conductivity and fire resistance characteristics. In addition, from Fig. 3, it is observed that, in the Example 1, aluminum hydroxide is almost uniformly dispersed without flocculation.

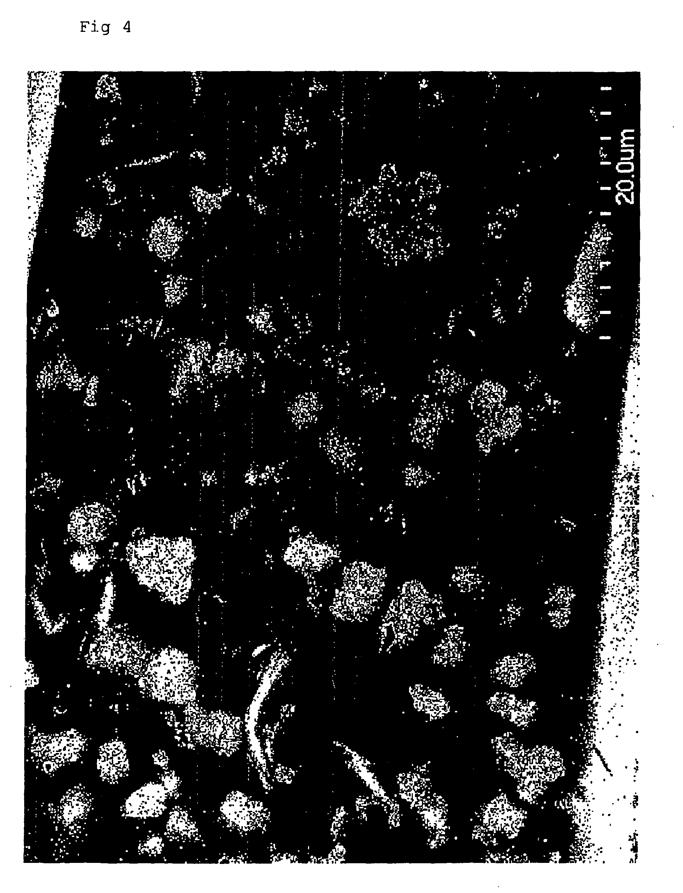

Compared with this, in the Comparison Example 1 in which proportions of the inorganic components are out of the ranges according to the invention, although fire retardancy complied with V0, low thermal conductivity was exhibited. Moreover, from Fig. 4 it is observed that aluminum hydroxide particles flocculate to form resin rich portions where thermal conductivity is made lowered.

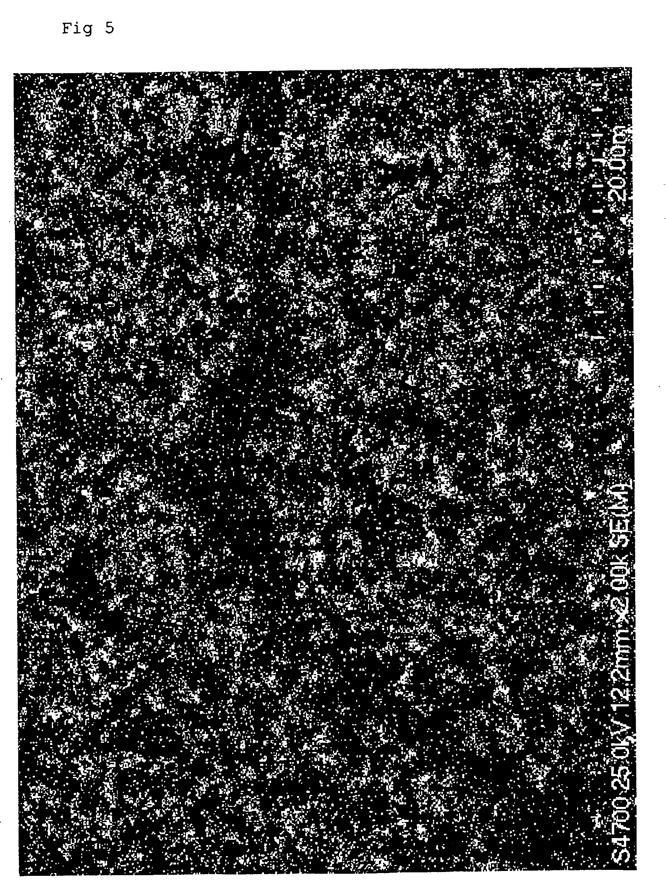

Furthermore, in the Comparison Example 2 in which content of aluminum hydroxide and content of phosphate ester are out of those according to the invention, high thermal conductivity was exhibited and no flocculation of aluminum hydroxide is caused as also observed from Fig. 5. However, presence of slightly resin rich layers caused fire retardancy to be V1.

As described above, according to the invention, a multilayered printed wiring board can be provided to which fire retardancy is imparted while reducing amounts of halogen compounds being used, yet which is made to have enhanced thermal conductivity of an insulator layer to prevent electronic parts from being damaged at soldering and is excellent in drilling machinability in forming through-holes.

## Claims

1. A multilayered printed wiring board wherein insulator layers each being formed with a glass cloth impregnated with epoxy resin composition and metal foil layers in each of which a circuit is formed are laminated alternately so that each of the above-described metal layers are disposed on each of a top and a bottom sides of the above-described insulator layer, and through-holes are further provided each for providing continuity between the metal foil layers laminated with the above-described insulator layer put between, the multilayered printed wiring board **characterized in that**
the above-described epoxy resin composition includes at least phosphate ester, aluminum hydroxide, silica, calcium oxide, strontium titanate, and iron oxide, and
contents of inorganic components in the above-described insulator layer are provided so as to be 8 to 18% by mass of phosphorus pentoxide (P₂O₅), 20 to 28% by mass of aluminum oxide (Al₂O₃), 0.1 to 0.6% by mass of silica (SiO₂), 0.1 to 1.0% by mass of chlorine (Cl), 15 to 20% by mass of calcium oxide (CaO), 0.3 to 0.5% by mass of titanium oxide (TiO₂), 0.2 to 0.4% by mass of iron oxide (Fe₂O₃ and 0.1 to 0.3% by mass of strontium oxide (SrO) in converted values measured by an X-ray fluorescence analysis.

2. The multilayered printed wiring board as claimed in claim 1 wherein the above-described aluminum hydroxide is made up of particles with irregular shapes having average particle diameter of 0.5 to 1.0µm almost uniformly distributed in the above-described insulator layer.

3. The multilayered printed wiring board as claimed in claim 1 or claim 2 wherein, at specified sections in the above-described metal foil layers and through-holes, there are formed solder layers which contain no lead.

4. The multilayered printed wiring board as claimed in any one of claim 1 to claim 3 wherein a surface of the multilayered printed wiring board except for sections to be soldered is coated with an insulation material containing phthalocyanine blue.

5. The multilayered printed wiring board as claimed in any one of claim 1 to claim 4 wherein amounts of gases evolved by a burning test at 600°C specified under JIS-K7217 are 150µg/g or less of chlorine, 30µg/g or less of bromine, 5mg/g or less of hydrogen cyanide, and 5mg/g or less of polychlorinated dibenzo-p-dioxin and polychlorinated dibenzo furan in mass ratio to the above-described multilayered printed wiring board.

6. The multilayered printed wiring board as claimed in any one of claim 1 to claim 5 wherein thermal conductivity of the above-described insulator layer is 0.4 to 0.5W/m/K.

## Patentansprüche

1. Mehrlagige gedruckte Leiterplatte, bei der Isolationsschichten, die jeweils mit einem Glasfasergewebe gebildet werden, das mit einer Epoxidharz-Zusammensetzung getränkt ist, und Metallfolienschichten, in denen jeweils eine Schaltung ausgebildet ist, abwechselnd zu einer Schichtstruktur aufgebaut werden, so dass jede der oben beschriebenen Metallschichten jeweils auf einer oberen und einer unteren Seite der oben beschriebenen Isolationsschicht angeordnet ist, und ferner Durchlochungen vorgesehen sind, jeweils zum Vorsehen einer Kontinuität zwischen den Metallfolienschichten, die mit der oben beschriebenen Isolationsschicht, die zwischen ihnen eingefügt ist, in einer Schichtstruktur aufgebaut sind, wobei die mehrlagige gedruckte Leiterplatte **dadurch gekennzeichnet ist, dass** die oben beschriebene Epoxidharz-Zusammensetzung mindestens Phosphatester, Aluminiumhydroxid, Siliziumdioxid, Calciumperoxid, Strontiumtitanat und Eisenoxid enthält, und
Inhalte anorganischer Bestandteile in der oben beschriebenen Isolationsschicht so vorgesehen sind, dass sie 8 bis 18 Masseprozent Phosphorpentoxid (P₂O₅), 20 bis 28 Masseprozent Aluminiumoxid (Al₂O₃), 0,1 bis 0,6 Masseprozent Siliziumdioxid (SiO₂) 0,1 bis 1,0 Masseprozent Chlor (Cl), 15 bis 20 Masseprozent Calciumoxid (CaO), 0,3 bis 0,5 Masseprozent Titanoxid (TiO₂), 0,2 bis 0,4 Masseprozent Eisenoxid (Fe₂O₃) und 0,1 bis 0,3 Masseprozent Strontiumoxid (SrO) in umgerechneten Werten, gemessen durch Röntgenfluoreszenzanalyse, betragen.

2. Mehrlagige gedruckte Leiterplatte nach Anspruch 1, wobei das oben beschriebene Aluminiumhydroxid aus Partikeln mit unregelmäßigen Formen mit einem durchschnittlichen Partikeldurchmesser von 0,5 bis 1,0 µm besteht, die in der oben beschriebenen Isolationsschicht fast gleichmäßig verteilt sind.

3. Mehrlagige gedruckte Leiterplatte nach Anspruch 1 oder Anspruch 2, wobei in vorbestimmten Abschnitten in den oben beschriebenen Metallfolienschichten und Durchlochungen Lotschichten ausgebildet sind, die kein Blei enthalten.

4. Mehrlagige gedruckte Leiterplatte nach einem der Ansprüche 1 bis 3, wobei eine Oberfläche der mehrlagigen gedruckte Leiterplatte außer in zu verlötenden Abschnitten mit einem Isolationsmaterial beschichtet ist, das Phthalocyaninblau enthält.

5. Mehrlagige gedruckte Leiterplatte nach einem der Ansprüche 1 bis 4, wobei Mengen von Gasen, die bei einem unter JIS-K7217 spezifizierten Brenntest bei 600°C freigesetzt werden, höchstens 150 µg/g Chlor, höchstens 30 µg/g Brom, höchstens 5 mg/g Cyanwasserstoffsäure und höchstens 5 mg/g polychloriertes Dibenzo-p-Dioxin und polychloriertes Dibenzofuran im Verhältnis zur Masse der oben beschriebenen mehrlagigen gedruckten Leiterplatte betragen.

6. Mehrlagige gedruckte Leiterplatte nach einem der Ansprüche 1 bis 5, wobei eine Wärmeleitfähigkeit der oben beschriebenen Isolationsschicht 0,4 bis 0,5 W/m/K beträgt.

## Revendications

1. Carte de circuit imprimé multicouche, dans laquelle des couches isolantes, chacune formée par une toile en verre imprégnée d'une composition de résine époxy, et des couches de feuille de métal, dans chacune desquelles un circuit est formé, sont laminées en alternance de sorte que chacune des couches métalliques décrites ci-dessus est disposée sur chacun d'un côté supérieur et d'un côté inférieur de la couche isolante décrite ci-dessus, et des trous traversants sont en outre prévus, chacun pour assurer une continuité entre les couches de feuille de métal laminées avec la couche isolante décrite ci-dessus placée entre celles-ci, la carte de circuit imprimé multicouche étant **caractérisée en ce que**
la composition de résine époxy décrite ci-dessus comprend au moins de l'ester de phosphate, de l'hydroxyde d'aluminium, de la silice, de l'oxyde de calcium, du titanate de strontium et de l'oxyde de fer, et
les teneurs en composants inorganiques dans la couche isolante décrite ci-dessus sont prévues de façon à représenter de 8 à 18 % en masse de pentoxyde de phosphore (P₂O₅), de 20 à 28 % en masse d'oxyde d'aluminium (Al₂O₃), de 0,1 à 0,6 % en masse de silice (SiO₂), de 0,1 à 1,0 % en masse de chlore (Cl), de 15 à 20 % en masse d'oxyde de calcium (CaO), de 0,3 à 0,5 % en masse d'oxyde de titane (TiO₂), de 0,2 à 0,4 % en masse d'oxyde de fer (Fe₂O₃), et de 0,1 à 0,3 % en masse d'oxyde de strontium (SrO) en valeurs converties mesurées par une analyse de fluorescence de rayonnement X.

2. Carte de circuit imprimé multicouche selon la revendication 1, dans laquelle l'hydroxyde d'aluminium décrit ci-dessus est composé de particules de formes irrégulières ayant un diamètre moyen de particule de 0,5 à 1,0 µm, réparties de façon presque uniforme dans la couche isolante décrite ci-dessus.

3. Carte de circuit imprimé multicouche selon la revendication 1 ou 2, dans laquelle, au niveau de sections spécifiées dans les couches de feuille de métal décrites ci-dessus et les trous traversants, des couches de métal de soudure sont formées qui ne contiennent pas de plomb.

4. Carte de circuit imprimé multicouche selon l'une quelconque des revendications 1 à 3, dans laquelle une surface de la carte de circuit imprimé multicouche, excepté les sections à souder, est recouverte d'un matériau d'isolation contenant du bleu de phtalocyanine.

5. Carte de circuit imprimé multicouche selon l'une quelconque des revendications 1 à 4, dans laquelle des quantités de gaz dégagées par un test de combustion à 600 °C spécifié selon JIS-K7217 correspondent à 150 µg/g ou moins de chlore, à 30 µg/g ou moins de brome, à 5 mg/g ou moins de cyanure d'hydrogène, et à 5 mg/g ou moins de dibenzo-p-dioxine polychlorée et de dibenzofurane polychloré en rapport de masse avec la carte de circuit imprimé multicouche décrite ci-dessus.

6. Carte de circuit imprimé multicouche selon l'une quelconque des revendications 1 à 5, dans laquelle une conductivité thermique de la couche isolante décrite ci-dessus est de 0,4 à 0,5 W/m/K.
